# EUROPEAN PATENT APPLICATION

(11) **EP 1 542 382 A1**
(43) Date of publication of application: **15.06.2005**
(21) Application number: 03360137.8
(22) Date of filing: 08.12.2003
(51) Int. Cl.: H04J 3/06

(54) **Input burst data stream transferring method and input circuit**

(71) Applicant: ALCATEL, 75008 Paris (FR)
(72) Inventor: Lautenschläger, Wolfram, 74343 Sachsensheim (DE)
(74) Representative: Kohler Schmid Möbus

(57) **Abstract**

This invention relates to a method for transferring an input data stream, comprising burst mode data packages, having an input data frequency, and a time gap in between two burst mode data packages into an output data stream, having an output data frequency and an input circuit for carrying out the method. The method is comprising the steps of attaining a write clock frequency out of an input data rate corresponding to the input data frequency of the burst mode data packages by inputting the input data stream into a clock recovery phase locked loop, writing the data of the burst mode data package into a data buffer using the write clock frequency, and reading out the output data stream from the data buffer using a read clock frequency according to the output data frequency, wherein the writing and the reading is done according to a first-in-first-out principle, wherein the steps of attaining a filling indicator value out of a filling level of the data buffer and controlling the write clock frequency during said time gaps by influencing the clock recovery phase locked loop according to the filling indicator value in a way that the filling level remains a given value in average, are performed.

## Description

This invention relates to an input data stream transferring method and an input circuit for carrying out the method. The method is used for transferring an input data stream, comprising burst mode data packages, having an input data frequency, and a time gap in between two burst mode data packages (bursty signal) into an output data stream, having an output data frequency. The method is comprising the steps of attaining a write clock frequency out of an input data rate corresponding to the input data frequency of the burst mode data packages by inputting the input data stream into a clock recovery phase locked loop (PLL), writing the data of the burst mode data package into a data buffer using the write clock frequency, and reading out the output data stream from the data buffer using a read clock frequency according to the output data frequency, wherein the writing and the reading is done according to a first-in-first-out (FIFO) principle. The input circuit preferably is part of a receiver for bursty signals of a transmission device, preferably used for asynchronous data packet transmission, e.g. in an electrical or optical way.

In a meshed digital network it is nearly impossible to run all nodes of the network in a bit synchronous way at any time. That means, if a receiving node runs at slower clock frequency than the transmitting node, the receiver virtually gets more bits than it expects with respect to its own clock and vice versa. Without proper mitigation this typically results in a first-in-first out memory over- or underrun. The problem is well known to most of the digital transmission systems and usually solved by use of so called stuff bits. These are bits, which can be removed from or inserted into the data stream, without effect to the higher layer protocols.
In a burst mode network the data payload is packed into isolated bursts, which are transmitted over a common medium, characterized by an optical fiber, wavelength, switches etc, in a time multiplexed way. At a receiver site that means bursts are arriving from different transmitters having crossed different transmission paths. Thus, every burst is arriving at its own power level and bit phase and at an unpredictable point in time. The receiver must be able to adapt very quickly to each burst in particular. For robustness reasons the distance between consecutive bursts has a lower bound, called e.g. guard time, guard band or safety gap.
Bit stuffing in burst mode is equally needed as in other transmission systems. The guard bands between the bursts are the natural reservoir for stuff bits. There are no extra stuff bits in the protocol. In fact, there is no guarantee for a specific number of bit periods between two bursts. It is up to the receiver, into how many bit it arranges the guard band span. Nevertheless, bit stuffing needs to be controlled in a way, that it is allowed only during the guard band, but never inside a burst.

According to prior art, there are solutions based on a receiver bitrate adaption between an external clock of a bursty signal and a local clock using a first-in-first-out principle. A bit stuffing is made during gaps between bursts by setting the write pointer of a FIFO buffer in a given position relative to the read pointer of the FIFO buffer.

A disadvantage of the existing solutions is that they require an explicit burst or packet detection. At high data rates this is uncertain and time consuming. The circuit used for burst or packet detection (detection path) is subject to propagation delay problems at high data rates.

It is therefore an object of the invention to provide a method for transferring an input data stream, comprising burst mode data packages, into an output data stream, and an input circuit for carrying out the method which overcome the problems associated with the related art, in particular which are applicable for transferring high data rates.

The object concerning the method for transferring an input data stream, comprising burst mode data packages, into an output data stream is attained by the method according to claim 1. The object concerning the input circuit is attained by the input circuit defined in claim 4.
Further advantageous features of the invention are defined in the depending claims.
The inventive method for transferring an input data stream, comprising burst mode data packages, having an input data frequency, and a time gap in between two burst mode data packages into an output data stream, having an output data frequency, is comprising the steps of
- attaining a write clock frequency out of an input data rate corresponding to the input data frequency of the burst mode data packages by inputting the input data stream into a clock recovery phase locked loop,
- writing the data of the burst mode data package into a data buffer using the write clock frequency, and
- reading out the output data stream from the data buffer using a read clock frequency according to the output data frequency, wherein the writing and the reading is carried out according to a first-in-first-out principle.

According to the invention the steps of attaining a filling indicator value out of a filling level of the data buffer and controlling the write clock frequency during said time gaps by influencing the clock recovery phase locked loop according to the filling indicator value in a way that the filling level remains a given value in average, are performed.

The inventive method results at least in the following advantages:
- Seamless bit stuffing in a burst mode receiver is possible.
- Receiver bitrate adaption to local clock speed without loss or duplication of relevant data bits is possible.
- The inventive method allows to use a packet format with high channel utilization, resulting in a reduced overhead, which otherwise only can be reached by performing complicated procedures.
- With moderate channel utilization the inventive method can still be implemented as a simplification of common receivers with benefits in robustness and costs.
- The method effects the required preamble length in burst mode at high data rates, e.g. 10 GBit/s and above.
- A reduction of necessary packet overhead can be made.
   Preferably, the input data stream is put into a phase discriminator of the clock recovery phase locked loop and the influencing of the clock recovery phase locked loop is done by applying a voltage into the clock recovery phase locked loop according to the filling indicator value. In the PLL the two signals, input data stream and applied voltage according to the filling indicator value, are compared, which leads to an implicit controlling of the filling level of the FIFO buffer.
   In another preferred embodiment of the inventive method the write clock frequency is attained by dividing the input data rate in a way that the write clock frequency is having a fixed ratio to the input data rate, preferably that the data of the burst mode data package is demultiplexed, wherein data words are written into the data buffer. Then the FIFO buffer would store data words instead of bits at a corresponding lower clock rate.
   According to the invention, the object concerning an input circuit for a burst mode receiver for carrying out the inventive method is achieved by an input circuit comprising
- clock recovery means, comprising a clock recovery phase locked loop and being designed to attain a write clock frequency out of an input data rate corresponding to an input data frequency of burst mode data packages of an input data stream by inputting the input data stream into the clock recovery phase locked loop,
- data buffer means, being designed to work according to a first-in-first-out principle and having the input data stream at a data input, wherein the data input is designed to run according to the write clock frequency and the data output is designed to run according to a read clock frequency of a read clock. Furthermore, control loop means are provided, comprising filling indicator means, being designed to attain a filling indicator value out of a filling level of the data buffer means and clock recovery phase locked loop influencing means, being designed to control the write clock frequency by influencing the clock recovery phase locked loop according to the filling indicator value in a way that the filling level remains a given value in average during time gaps between burst mode data packages. The PLL is a fast acquisition PLL, which is burst-mode-enabled. For using the inventive input circuit in combination with a band filter clock or data recovery, it has to be adopted. In the inventive input circuit no explicit packet detection, e.g. a separate decision logic, is required, thus timing constrains are avoided, leading to an applicability to highest data rates. A reduction of the complexity of a burst mode data reception system is made possible.

Preferably, the control loop means of the inventive input circuit are implemented as a second control loop coinciding in part with the clock recovery phase locked loop, and the second control loop is designed to be dominated by the clock recovery phase locked loop, while the input data stream contains a burst mode data package. The second control loop dominates the clock recovery phase locked loop, while the input data stream contains no data packet, i.e. during the gaps. This implementation leads to the possibility to avoid any additional circuitry for switching between the first and the second control loop.

Preferably, the clock recovery phase locked loop is comprising a phase discriminator, having the input data stream at its input and a Voltage Controlled Oscillator, and the clock recovery phase locked loop influencing means of the second control loop are designed to apply a voltage to the clock recovery phase locked loop according to the filling indicator value, wherein the Voltage Controlled Oscillator is being part of the second control loop. This implementation uses the PLL structure comprising a VCO of burst mode data receivers according to the state of the art. Even the second control loop is implemented using given structures.

Preferably, the clock recovery phase locked loop influencing means are comprising filtering stage means, being designed to attain the voltage according to the filling indicator value, preferably comprising means to evaluate a sign function from the filling indicator value followed by a low pass filter. This implementation leads to simple and robust control circuits.

In another preferred embodiment of the inventive circuit, a digital frequency dividing circuit is provided, being designed to attain the write clock frequency by dividing the input data rate in a way that the write clock frequency is having a fixed ratio to the input data rate, preferably that a demultiplexer is provided, being designed to demultiplex the data of the burst mode data packages, resulting in that data words are written into the data buffer means. Therefore a lower write and/or read clock frequency can be used.

The inventive input circuit is preferably used as a part of a burst mode receiver, which preferably is part of a transmission device, e.g. for the transmission of optical signals.

The different features of the preferred embodiments of the invention may be used in combination together with the invention as set forth in the independent claims or just each single preferred embodiment together with the invention as set forth in the independent claims.

The embodiments of the invention will now be described with reference to the accompanying drawings.
In fig. 1 a block diagram of a FIFO buffer controlling having an explicit packet detector is shown according to the state of the art.
In fig. 2 a block diagram of an inventive input circuit is shown, which enables seamless bit stuffing using an additional feedback device K.
In fig. 3 an illustration of an operating mode during a burst, i.e. when the input data stream consists of a burst mode data packet, of the inventive input circuit shown in fig. 2, is shown.
In fig. 4 an illustration of an operating mode during a gap between bursts, i.e. when the input data stream consists of no burst mode data packet, of the inventive input circuit shown in fig. 2, is shown.

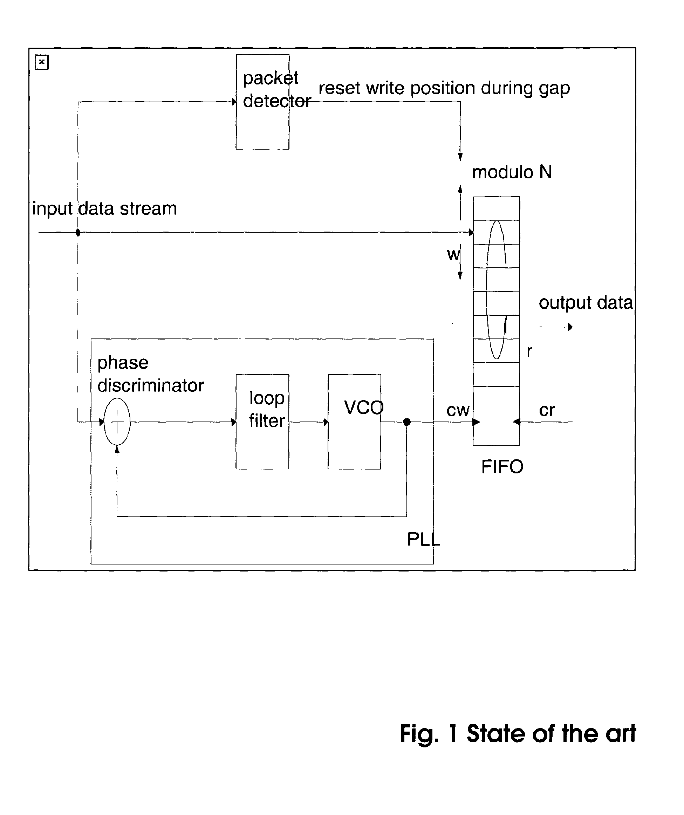

Figure 1 shows a typical receiver structure according to the state of the art. A clock recovery circuit, implemented as a PLL derives a clock that fits in average to the logic level transitions in the input data stream. In the PLL two signals, an incoming signal and a locally created signal, are compared according to their phase. The result is expressed e.g. as a voltage. For example: if the locally created signal is later than the incoming signal this is expressed in a positive voltage and if the locally created signal is earlier than the incoming signal this is expressed in a negative voltage. This voltage is applied to a voltage controlled oscillator (VCO), which, for example, oscillates with a higher frequency if a positive voltage is applied and oscillates with a lower frequency, if a negative voltage is applied. This can be expressed as a continuously growing phase shift, because the phase is an integral of the frequency over time. The output signal of the VCO is the locally created signal of the phasediscriminator, which leads to an implementation of a control loop of the phaseshift. The loop filter suppresses distortion signals of the phasediscriminator and defines characteristics of the control loop, as e.g. stability and oscillation behavior. According to its character the loop filter is a low pass filter and no band filter, having a resonant frequency. The input data stream is written to a FIFO buffer under control of a recovered clock (cw) by moving the write position (w) from storage cell to storage cell. The position cycles modulo of the FIFO buffer size N. The system clock of a local node (cr) moves the read position cell by cell, where the data is read out from the FIFO buffer. Ideally, the distance between read and write position is w-r = N/2 taken modulo N, what defines the given value which the filling level of the FIFO buffer remains in average during time gaps. If the write clock is faster or slower than the read clock, the distance w-r grows or shrinks with the danger of passing each other in one or the other direction.
A packet detector is used to determine whether a burst mode data packet or a gap is on input. During the gap the input data stream does not contain relevant bits. It is no loss of information if the continuous cycling of the write position is interrupted and reset to the correct distance w-r = N/2. The packet detection must be fast enough to release the write position cycling on time at beginning of the next burst mode packet. This causes a stiff timing constraint between packet detection and FIFO control. It is hard to design a quick and reliable packet detector in the presence of heavy noise as it is in amplified optical systems, e.g. an Erbium-Doped Fiber Amplifier (EDFA). This causes an extra overhead that is required in the burst mode reception of data.

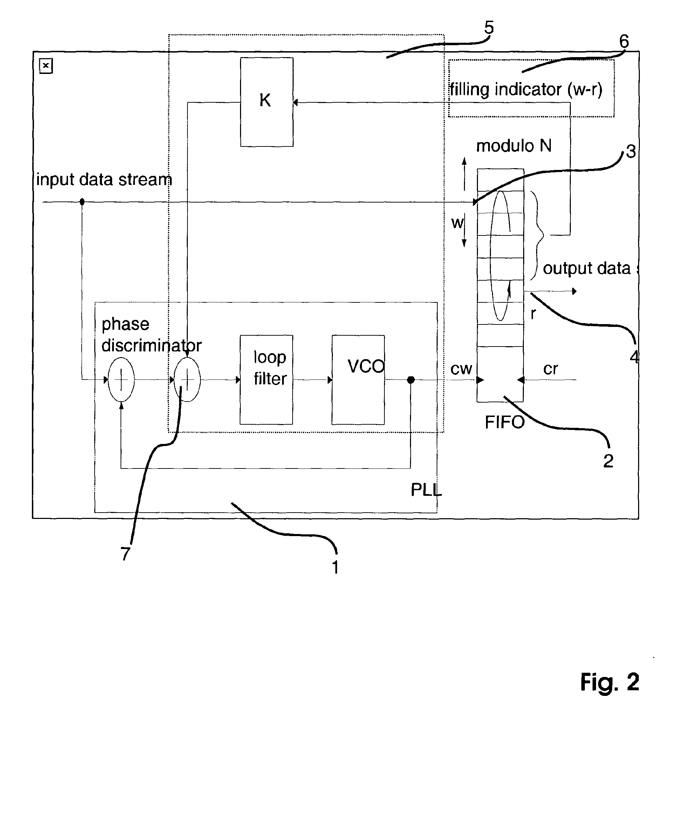

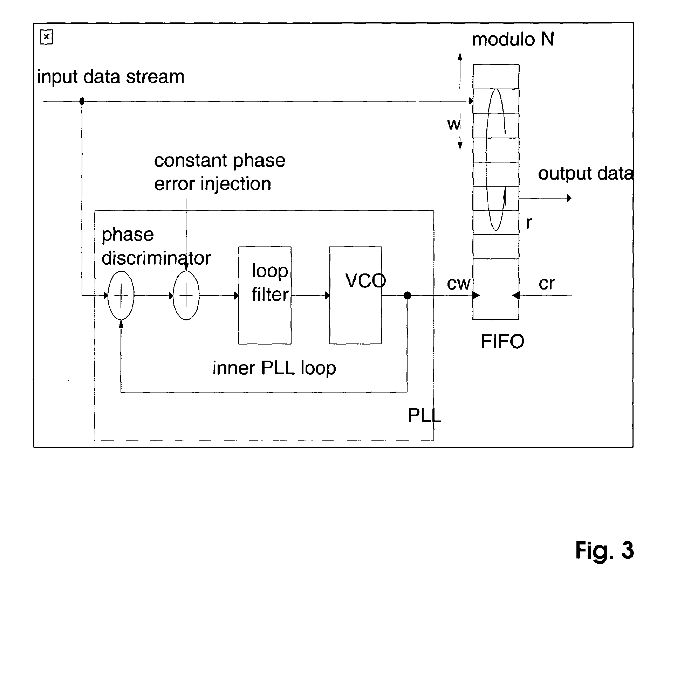

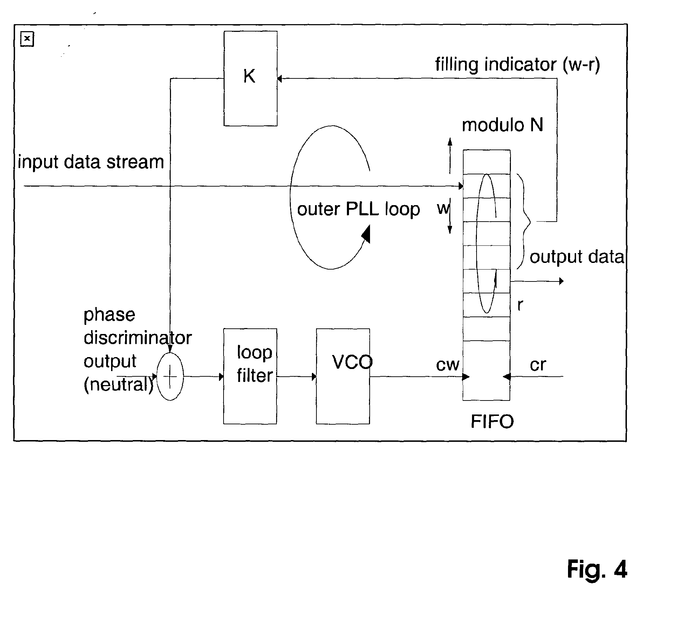

In fig. 2 a block diagram of an inventive input circuit is shown, which enables seamless bit stuffing using an additional feedback device K. The inventive input circuit for a burst mode receiver for carrying out the inventive method according is comprising clock recovery means, comprising a clock recovery phase locked loop and being designed to attain a write clock frequency cw out of an input data rate corresponding to an input data frequency of burst mode data packages of an input data stream by inputting the input data stream into the clock recovery phase locked loop 1, data buffer means 2, being designed to work according to a first-in-first-out principle and having the input data stream at a data input, wherein the data input 3 is designed to run according to the write clock frequency and the data output 4 is designed to run according to a read clock frequency of a read clock cr, wherein control loop means 5 are provided, comprising filling indicator means 6, being designed to attain a filling indicator value w-r out of a filling level of the data buffer means and clock recovery phase locked loop influencing means 7, being designed to control the write clock frequency by influencing the clock recovery phase locked loop according to the filling indicator value in a way that the filling level remains a given value in average during time gaps between burst mode data packages. Two inter-linked control loops for controlling a write clock cw of the FIFO buffer are used. A first control loop being the clock recovery PLL is controlling the clock recovery of the input data stream, when consisting a burst mode data packed. A Phase discriminator included in the clock recovery PLL, outputs a statistically changing control value with a mean value of zero during gaps, thus having no influence to the first control loop during gaps, e.g. it is not effective between two burst mode data packages, but dominates the second control loop when effective. A second control loop is controlling the filling of the FIFO buffer without relevant influence when burst mode data packages are received, meaning when the first control loop is actively recovering the input data clock, but having exclusive influence on the write clock frequency during gaps. Both control loops are working on a common voltage controlled oscillator (VCO). Amplitudes and bandwith of the control signals of the two control loops are harmonized in a way that the second control loop is overruled by the first control loop as long as the input signal is containing a burst mode data package. The second control loop is coinciding in part with the first control loop and is influencing the write clock frequency in such a manner, that the filling level of the FIFO buffer remains a given value in average. The inventive method and the inventive input circuit are based on the idea to insert an additional feedback from the FIFO buffer filling indicator (w-r) to the PLL error signal by means of an appropriate shaping and/or filtering device K, according to figure 2. This results in a tandem solution, wherein a clock recovery PLL and a FIFO buffer control PLL are combined, each of them operating only in one mode of two possible modes:
1. mode (data): a data packet is received, as shown in fig. 3, and
2. mode (noise): time gap between two received data packets, as shown in fig. 4.
The transition between both modes is implicit by correlation features of the input data stream (input signal) depending whether noise or data are received. Alternatively, the additional feedback can be injected into the PLL loop at any point between phase discriminator and VCO.
During the reception of a burst mode data packet both write clock (cw) and read clock (cr) have nearly equal frequencies, the FIFO filling does not change, resulting in that the additional feedback signal is constant, and can be regarded as an independent constant phase error injection, as shown in figure 3. The inner PLL operates as expected with a slightly shifted phase, the FIFO filling has no explicit effect.
In contrary, during a gap, the input signal contains no transitions (zeros level) or uncorrelated transitions (noise). In this case the phase discriminator delivers a phase error signal, which is neutral in average resulting in that the inner PLL control loop is not active anymore, the neutral phase detector signal can be ignored, as shown in figure 4. This results in an outer PLL loop, which is using the FIFO buffer as phase detector. If the FIFO buffer filling is too high, the VCO is slowed down a bit and vice versa, until the filling is back to (w-r) = N/2.

The filtering stage K is, in its simplest form, a sign function followed by a low pass filter. Other digital circuitry can be positioned between PLL and FIFO buffer, as long as the data rate and clock rate at the FIFO write input have a fixed ratio to the VCO frequency. As an example, the data could pass a demultiplexer, where the FIFO would store data words instead of bits at a corresponding lower clock rate.
The outer PLL loop is not required to equalize the FIFO filling in a rapid way. It is a means to keep the filling rate at N/2 during the gap, and not to allow the otherwise free running VCO to diverge far away from this position. This idea allows to dimension K in such a way, that the phase error during the packet remains sufficiently small.
Furthermore, the transition from gap to packet and vice versa is an implicit process not requiring extra control signals or detector devices. This way, it avoids any kind of timing or propagation delay constraints, and thus is applicable to highest transmission speeds.
Both read and write positions are never explicitly stopped or reset. This avoids any problem with false reset signals from packet detection, or duplicated read of old FIFO buffer content.

## Claims

1. A method for transferring an input data stream, comprising burst mode data packages, having an input data frequency, and a time gap in between two burst mode data packages into an output data stream, having an output data frequency, comprising the steps of
- attaining a write clock frequency out of an input data rate corresponding to the input data frequency of the burst mode data packages by inputting the input data stream into a clock recovery phase locked loop,
- writing the data of the burst mode data package into a data buffer using the write clock frequency, and
- reading out the output data stream from the data buffer using a read clock frequency according to the output data frequency, wherein the writing and the reading is done according to a first-in-first-out principle,
**characterised in that** the steps of
- attaining a filling indicator value out of a filling level of the data buffer and
- controlling the write clock frequency during said time gaps by influencing the clock recovery phase locked loop according to the filling indicator value in a way that the filling level remains a given value in average, are performed.

2. The method according to claim 1, **characterised in that**
the input data stream is put into a phase discriminator of the clock recovery phase locked loop and the influencing of the clock recovery phase locked loop is done by applying a voltage into the clock recovery phase locked loop according to the filling indicator value.

3. The method according to claim 1, **characterised in that**
the write clock frequency is attained by dividing the input data rate in a way that the write clock frequency is having a fixed ratio to the input data rate, preferably that the data of the burst mode data package is demultiplexed, wherein data words are written into the data buffer.

4. An input circuit for a burst mode receiver for carrying out the method according to claim 1, comprising
- clock recovery means, comprising a clock recovery phase locked loop and being designed to attain a write clock frequency out of an input data rate corresponding to an input data frequency of burst mode data packages of an input data stream by inputting the input data stream into the clock recovery phase locked loop,
- data buffer means, being designed to work according to a first-in-first-out principle and having the input data stream at a data input, wherein the data input is designed to run according to the write clock frequency and the data output is designed to run according to a read clock frequency of a read clock,
**characterised in that**
control loop means are provided, comprising
- filling indicator means, being designed to attain a filling indicator value out of a filling level of the data buffer means and
- clock recovery phase locked loop influencing means, being designed to control the write clock frequency by influencing the clock recovery phase locked loop according to the filling indicator value in a way that the filling level remains a given value in average during time gaps between burst mode data packages.

5. The input circuit according to claim 4, **characterised in that**
the control loop means are implemented as a second control loop coinciding in part with the clock recovery phase locked loop, and that the second control loop is designed to be dominated by the clock recovery phase locked loop, while the input data stream contains a burst mode data package.

6. The input circuit according to claim 5, **characterised in that**
- the clock recovery phase locked loop is comprising a phase discriminator, having the input data stream at its input and a Voltage Controlled Oscillator, and
- the clock recovery phase locked loop influencing means of the second control loop are designed to apply a voltage to the clock recovery phase locked loop according to the filling indicator value, wherein the Voltage Controlled Oscillator is being part of the second control loop.

7. The input circuit according to claim 6, **characterised in that**
the clock recovery phase locked loop influencing means are comprising filtering stage means, being designed to attain the voltage according to the filling indicator value, preferably comprising means to evaluate a sign function from the filling indicator value followed by a low pass filter.

8. The input circuit according to claim 4, **characterised in that**
a digital frequency dividing circuit is provided, being designed to attain the write clock frequency by dividing the input data rate in a way that the write clock frequency is having a fixed ratio to the input data rate, preferably that a demultiplexer is provided, being designed to demultiplex the data of the burst mode data packages, resulting **in that** data words are written into the data buffer means.

9. A burst mode receiver comprising an input circuit according to claim 8.

10. A transmission device comprising a receiver according to claim 9.
